# EUROPÄISCHE PATENTSCHRIFT

(11) **EP 3 066 805 B1**
(45) Veröffentlichungstag und Bekanntmachung des Hinweises auf die Patenterteilung: **03.04.2019**
(21) Anmeldenummer: 14786506.7
(22) Anmeldetag: 20.10.2014
(51) Int. Cl.: H04L 25/02

(54) **TEILNEHMERSTATION FÜR EIN BUSSYSTEM UND VERFAHREN ZUR REDUZIERUNG VON LEITUNGSGEBUNDENEN EMISSIONEN IN EINEM BUSSYSTEM**
SUBSCRIBER STATION FOR A BUSSYSTEM AND METHOD FOR REDUCTION OF ELECTROMAGNETIC EMISSIONS IN A BUSSYSTEM
POSTE DU RÉSEAU D'UN SYSTÈME DE BUS ET PROCÉDÉ POUR LA RÉDUCTION D'ÉMISSIONS ÉLECTROMAGNÉTIQUES DANS UN SYSTÈME DE BUS

(30) Priorität: 08.11.2013 DE 102013222782
(43) Veröffentlichungstag der Anmeldung: 14.09.2016
(73) Patentinhaber: Robert Bosch GmbH, 70442 Stuttgart (DE)
(72) Erfinder: WALKER, Steffen, 72770 Reutlingen (DE); PANNWITZ, Axel, 01445 Radebeul (DE)
(86) Internationale Anmeldenummer: PCT/EP2014/072416
(87) Internationale Veröffentlichungsnummer: WO 2015/067460

(56) Entgegenhaltungen:
- EP-A1- 1 376 962
- WO-A1-2006/133731
- US-A1- 2010 201 399

## Beschreibung

### Technisches Gebiet

Die vorliegende Erfindung betrifft eine Teilnehmerstation für ein Bussystem und ein Verfahren zur Reduzierung von leitungsgebundenen Emissionen in einem Bussystem, bei welchem eine Symmetrierung des Dominant-Buszustands erreicht wird.

### Stand der Technik

Der CAN-Bus ist ein differentielles Bussystem mit hohen Anforderungen an die Signalsymmetrierung. Hierbei gilt, je besser die Signalsymmetrierung desto geringer die hochfrequente Störabstrahlung und die Störungen bei Hochfrequenzempfängern, wie beispielsweise einem Autoradio, GPS, Funktelefon, usw. Die gegenphasigen Signale CAN_H und CAN_L müssen derart gesteuert werden, dass ihr Mittelwert möglichst wenig von der Mittenspannung VCC5/2=2.5V abweicht.

Derzeit wird die Signalsymmetrierung dadurch erzielt, dass die Widerstände der Schalter nach Masse GND und zum Potential VCC5 so balanciert werden, dass im Dominant-Buszustand oder Dominantzustand des Busses, bei welchem die Differenzspannung der Signale CAN_H - CAN_L einen Wert von ca. 2V hat, die Mittelwertspannung bei 2.5V liegt. Das Ausbalancieren der Schalterwiderstände geschieht beispielsweise durch geschickte Dimensionierung oder durch Regelschaltungen, die beispielsweise in der DE10250576A1 beschrieben sind.

Problematisch ist jedoch zum einen, dass bisher kein On-Chip-Abgleich der Symmetrie durchführbar ist. Zum anderen ist derzeit auch bei Alterung und Temperaturdrift keine optimale Symmetrierung möglich. Darüber hinaus soll eine signifikante Verringerung der abgestrahlten Störungen erzielt werden.

US 2010/0201399 A1 beschreibt eine Treiberschaltung für einen Zweidrahtleiter und ein Verfahren zur Erzeugung von zwei Ausgangsströmen für einen Zweidrahtleiter in Bezug auf das CAN-Bussystem, bei welchen mit einem Controller softwaretechnisch mit Hilfe von Steuersignalen die Flanken von CAN_H und CANL jeweils relativ zueinander abgeglichen werden.

EP 1 376 962 A1 zeigt eine Kommunikationsvorrichtung mit einem Treiber zum Anlegen eines geschalteten Signals an eine CAN-Bus-Kommunikationsleitung mit einer gesteuerten Flankensteilheit.

WO 2006/133731 A1 zeigt ein Kommunikationssystem mit einem CAN-Bus, bei welchem die nichtideale Symmetrie zwischen Komponenten in verdrillten Aderpaarpfaden betrachtet wird.

### Offenbarung der Erfindung

Daher ist es Aufgabe der vorliegenden Erfindung, eine Teilnehmerstation für ein Bussystem und ein Verfahren bereitzustellen, welche die zuvor genannten Probleme lösen. Insbesondere sollen eine Teilnehmerstation für ein Bussystem und ein Verfahren bereitgestellt werden, bei welchen eine signifikante Verringerung der abgestrahlten Störungen möglich ist und Anforderungen an die Symmetrierung des Bussignals auch bei Alterung und Temperaturdrift erfüllt werden.

Die Aufgabe wird durch eine Teilnehmerstation für ein Bussystem nach Patentanspruch 1 gelöst. Die Teilnehmerstation umfasst einen Digital-Analog-Wandler zum Wandeln eines digitalen Signals in ein analoges Signal, und einen Analog-/Digital-Wandler, wobei der Digital-Analog-Wandler und der Analog-/Digital-Wandler für einen Symmetrieabgleich des Dominant-Buszustands des Bussystems verschaltet sind, wie in Anspruch 1 beschrieben.

Mit der Teilnehmerstation ist es möglich, den Dominant-Buszustand zu symmetrieren. Damit können Stromfehler in unterschiedlichen Signalpfaden vermieden werden, die aufgrund von Bauelemente-Fehlanpassung (Bauelemente-Mismatch) auftreten können.

Zudem ist mit der Teilnehmerstation ein On-Chip-Abgleich der Symmetrierung realisierbar, wobei auch ein Abgleich beim Endtest möglich ist.

Ein weiterer Vorteil der Teilnehmerstation besteht darin, dass eine optimale Symmetrierung auch bei Alterung und Temperaturdrift möglich ist.

Vorteilhafte weitere Ausgestaltungen der Teilnehmerstation sind in den abhängigen Patentansprüchen angegeben.

Bei der Teilnehmerstation ist es möglich, dass der Digital-Analog-Wandler zum zyklischen Ausführen und/oder zum On-Chip-Ausführen des Symmetrieabgleichs ausgestaltet ist.

Die Teilnehmerstation kann zudem einen flüchtigen Speicher aufweisen, in welchem ein Steuerwort des Digital-Analog-Wandlers zum Durchführen des Symmetrieabgleichs abgelegt ist.

Darüber hinaus kann die Teilnehmerstation zudem einen Schalter zum Trennen des Digital-Analog-Wandlers und des Analog-/Digital-Wandlers von einem Bus des Bussystems aufweisen, um den Symmetrieabgleich durchzuführen. Hierbei kann der Schalter eine PMOS-HV-Kaskode und eine NMOS-HV-Kaskode umfassen, welche zum Durchführen des Symmetrieabgleichs hochohmig schaltbar sind, um den Digital-Analog-Wandler und den Analog-/Digital-Wandler von einem Bus des Bussystems zu trennen.

Außerdem ist es möglich, dass die Teilnehmerstation einen Kurzschlusspfad von einem NV-NMOS-Transistor zu einem NV-PMOS-Transistor zum Starten einer digitalen Regelschleife für den Symmetrieabgleich umfasst.

Die zuvor beschriebene Teilnehmerstation kann Teil eines Bussystems sein, das einen Bus, und mindestens zwei Teilnehmerstationen aufweist, welche über den Bus derart miteinander verbunden sind, dass sie miteinander kommunizieren können, wobei mindestens eine der mindestens zwei Teilnehmerstationen eine der zuvor beschriebenen Teilnehmerstation ist.

Die zuvor genannte Aufgabe wird zudem durch ein Verfahren zur Reduzierung von leitungsgebundenen Emissionen in einem Bussystem nach Patentanspruch 12 gelöst. Bei dem Verfahren sind bei einer Teilnehmerstation des Bussystems ein Digital-Analog-Wandler zum Wandeln eines digitalen Signals in ein analoges Signal und ein Analog-/Digital-Wandler vorgesehen, wobei der Digital-Analog-Wandler und der Analog-/Digital-Wandler derart miteinander verschaltet werden, dass der Digital-Analog-Wandler und der Analog-/Digital-Wandler einen Symmetrieabgleich des Dominant-Buszustands des Bussystems durchführen, wie in Anspruch 12 beschrieben.

Das Verfahren bietet dieselben Vorteile, wie sie zuvor in Bezug auf die Teilnehmerstation genannt sind.

Vorteilhafte weitere Ausgestaltungen des Verfahrens sind in den abhängigen Patentansprüchen angegeben.

Bei dem Verfahren kann das Ausführen des Symmetrieabgleichs zyklisch und/oder als On-Chip-Symmetrieabgleich ausgeführt werden.

Zusätzlich oder alternativ ist es zum Durchführen des Symmetrieabgleichs bei dem Verfahren möglich, ein Steuerwort des Digital-Analog-Wandlers zu verwenden, das in einem flüchtigen Register abgelegt ist.

Zudem kann zum Durchführen des Symmetrieabgleichs eine PMOS-HV-Kaskode und eine NMOS-HV-Kaskode hochohmig geschaltet werden, um den Digital-Analog-Wandler und den Analog-/Digital-Wandler von einem Bus des Bussystems zu trennen. , Dadurch kann mit einem Kurzschlusspfad von einem strombestimmenden Element auf der Seite eines Ausgangsstromspiegels CAN_H zu einem strombestimmenden Element auf der Seite eines Ausgangsstromspiegels CAN_L eine digitale Regelschleife, bei welcher der Strom des strombestimmenden Elements auf der Seite des Ausgangsstromspiegels CAN_H und der Strom des strombestimmenden Elements auf der Seite des Ausgangsstromspiegels CAN_L auf einen annähernd gleichen Wert geregelt wird, für den Symmetrieabgleich gestartet werden.

Weitere mögliche Implementierungen der Erfindung umfassen auch nicht explizit genannte Kombinationen von zuvor oder im Folgenden bezüglich des Ausführungsbeispiels beschriebenen Merkmale oder Ausführungsformen. Dabei wird der Fachmann auch Einzelaspekte als Verbesserungen oder Ergänzungen zu der jeweiligen Grundform der Erfindung hinzufügen.

### Zeichnungen

Nachfolgend ist die Erfindung unter Bezugnahme auf die beiliegende Zeichnung und anhand eines Ausführungsbeispiels näher beschrieben. Es zeigen:
Fig. 1 ein vereinfachtes Blockschaltbild eines Bussystems gemäß einem Ausführungsbeispiel;
Fig. 2 einen Sollspannungsverlauf eines Bussignals über der Zeit im Bussystem gemäß dem Ausführungsbeispiel; und
Fig. 3 ein elektrisches Schaltbild einer Sendeeinrichtung einer Teilnehmerstation des Bussystems gemäß dem Ausführungsbeispiel;

In den Figuren sind gleiche oder funktionsgleiche Elemente, sofern nichts anderes angegeben ist, mit denselben Bezugszeichen versehen.

### Beschreibung des Ausführungsbeispiels

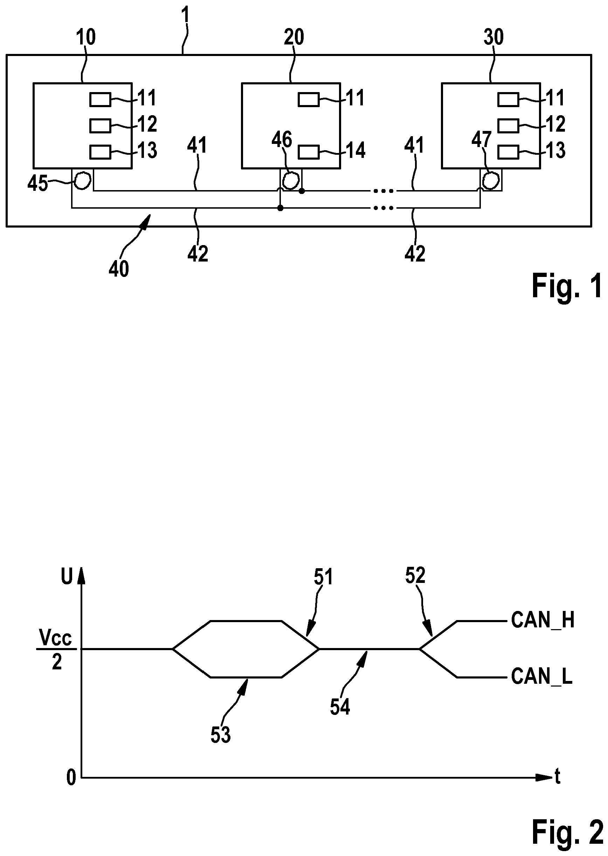

Fig. 1 zeigt ein Bussystem 1, das beispielsweise ein CAN-Bussystem, ein CAN-FD-Bussystem, usw., sein kann. Das Bussystem 1 kann in einem Fahrzeug, insbesondere einem Kraftfahrzeug, einem Flugzeug, usw., oder im Krankenhaus usw. Verwendung finden.

In Fig. 1 hat das Bussystem 1 eine Vielzahl von Teilnehmerstationen 10, 20, 30, die jeweils an einen Bus 40 mit einer ersten Busader 41 und einer zweiten Busader 42 angeschlossen sind. Die Busadern 41, 42 können auch CAN_H und CAN_L genannt werden und dienen zur Einkopplung der dominanten Pegel im Sendezustand. Über den Bus 40 können Nachrichten 45, 46, 47 in der Form von Signalen zwischen den einzelnen Teilnehmerstationen 10, 20, 30 übertragen werden. Die Teilnehmerstationen 10, 20, 30 können beispielsweise Steuergeräte oder Anzeigevorrichtungen eines Kraftfahrzeugs sein.

Wie in Fig. 1 gezeigt, haben die Teilnehmerstationen 10, 30 jeweils eine Kommunikationssteuereinrichtung 11, eine Sendeeinrichtung 12, und eine Empfangseinrichtung 13. Die Teilnehmerstation 20 hat dagegen eine Kommunikationssteuereinrichtung 11 und eine Sende-/Empfangseinrichtung 14. Die Sendeeinrichtungen 12, die Empfangseinrichtungen 13 der Teilnehmerstationen 10, 30 und die Sende-/Empfangseinrichtung 14 der Teilnehmerstationen 20 sind jeweils direkt an den Bus 40 angeschlossen, auch wenn dies in Fig. 1 nicht dargestellt ist.

Die Kommunikationssteuereinrichtung 11 dient zur Steuerung einer Kommunikation der jeweiligen Teilnehmerstation 10, 20, 30 über den Bus 40 mit einer anderen Teilnehmerstation der an den Bus 40 angeschlossenen Teilnehmerstationen 10, 20, 30. Die Sendeeinrichtung 12 dient zum Senden der Nachrichten 45, 47 in Form von Signalen und zur Reduzierung von leitungsgebundenen Emissionen im Bussystem 1, um die Anforderungen des Bussystems 1 an die Signalsymmetrierung zu erfüllen, wie später noch ausführlicher beschrieben. Leitungsgebundene Emissionen können auf dem Bus 40 auftreten. Die Kommunikationssteuereinrichtung 11 kann wie ein herkömmlicher CAN-Controller ausgeführt sein. Die Empfangseinrichtung 13 kann in Bezug auf ihre Empfangsfunktionalität wie ein herkömmlicher CAN-Transceiver ausgeführt sein. Die Sende-/Empfangseinrichtung 14 kann wie ein herkömmlicher CAN-Transceiver ausgeführt sein.

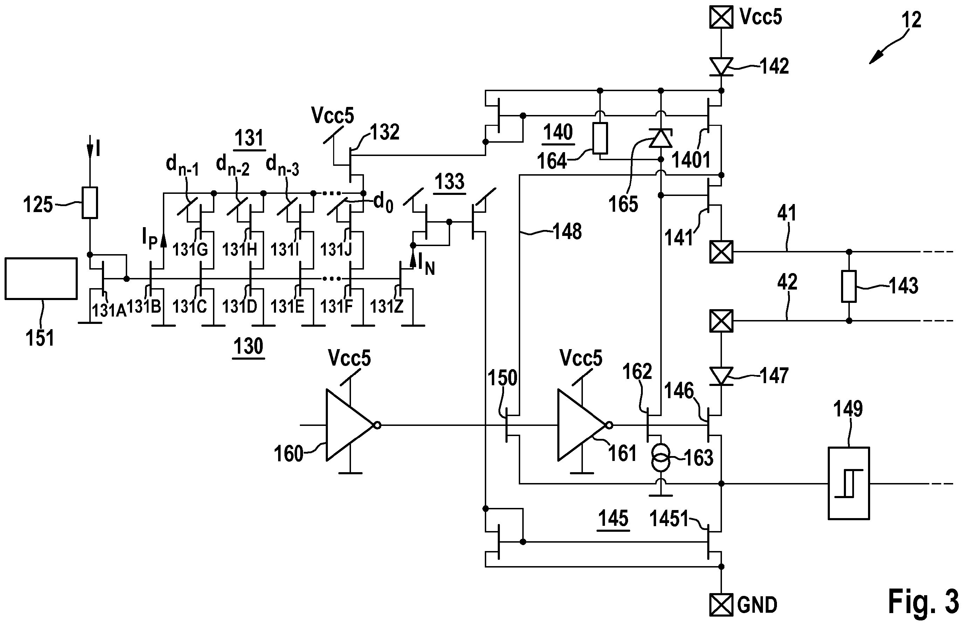

Fig. 2 zeigt einen Spannungsverlauf U über der Zeit t mit Schaltflanken 51, 52, wie er von der Sendeeinrichtung 12 erzeugt wird, die in Fig. 3 genauer dargestellt ist. Die Schaltflanke 51 entspricht einem Übergang des Signals vom dominanten Zustand 53 zum rezessiven Zustand 54. Die Schaltflanke 52 entspricht einem Übergang des Signals vom rezessiven Zustand 54 zum dominanten Zustand 53. Der dargestellte Spannungsverlauf hat Schaltflanken 51, 52, wie ein von der Sendeeinrichtung 12 zu erzeugender Sollspannungsverlauf. Der dominante Zustand 53 entspricht einem Dominant-Buszustand. Der rezessive Zustand 54 entspricht einem Rezessiv-Buszustand.

Gemäß Fig. 3 umfasst die Sendeeinrichtung 12 eine Strombank 130, in welche ein Eingangssignal oder der Eingangsstrom I von einem nicht dargestellten PMOS-Transistor über einen Widerstand 125 eingespeist wird, , einen Ausgangsstromspiegel CAN_H 140, welcher den Strom zur Busader 41 (CAN_H) leitet, und einen Ausgangsstromspiegel CAN_L 145, welcher den Strom zur Busader 42 (CAN_L.) leitet.

Die Strombank 130 umfasst einen Stromspiegel 131, der aus NMOS-Transistoren 131A, 131B und einem Digital-Analog-Wandler gebildet wird, von welchem in Fig. 3 als ein spezielles Beispiel die Transistoren 131C, 131D, 131E, 131F, 131G, 131H, 131I, 131J dargestellt sind. Tatsächlich hat der Stromspiegel 131 eine Anzahl von n Transistoren 131C, 131D, 131E, 131F im Digital-Analog-Wandler und eine Anzahl von n Transistoren als Schalter, wobei n eine natürliche Zahl größer 1 ist. Somit gilt bei dem Beispiel von Fig. 3 n = 4. Zudem hat die Strombank 130 eine NMOS-Hochspannungs-Kaskode 132, die nachfolgend auch NMOS-HV-Kaskode 132 genannt ist, und einen PMOS-Stromspiegel 133 für Niederspannung (low voltage). Die NMOS-HV-Kaskode 132 ist mit dem Ausgangsstromspiegel 140 verbunden. Der PMOS-Stromspiegel 133 ist mit dem Ausgangsstromspiegel 145 verbunden.

Die Transistoren 131C, 131D, 131E, 131F, 131G, 131H, 131I, 131J bilden einen Strom-Digital-Analog-Wandler mit der Wortbreite n. In Reihe zu jedem von den Transistoren 131C, 131D, 131E, 131F gebildeten Stromquellen-Ausgang mit binärer Gewichtung ist einer der Transistoren 131G, 131H, 131I, 131J als Schalttransistor 131 geschaltet, welcher vom jeweiligen Datenbit dₙ₋₁, dₙ₋₂, dₙ₋₃ bis d₀ gesteuert wird.

Da in die Strombank 130 das Eingangssignal oder der Eingangsstrom I von dem nicht dargestellten PMOS-Transistor eingespeist wird, ist der Widerstand 125 nicht an ein festes Potential angeschlossen. Der NMOS-Transistor 131B neben dem Eingang der Strombank 130 liefert den Grundstrom I_{P} für die PMOS-Seite der Strombank 130. Hierbei ist der Grundstrom I_{P} der typische Strom minus die Hälfte (1/2) eines Abgleichstroms, wobei 1/2 des Abgleichstroms in dem Pfad der Transistoren 131C, 131G fließt, 1/4 des Abgleichstroms in dem Pfad der Transistoren 131D, 131H fließt, 1/8 des Abgleichstroms in dem Pfad der Transistoren 131E, 131I, usw. und 1/2ⁿ des Abgleichstroms in dem Pfad der Transistoren 131F, 131J fließt, welcher der n-te Transistorpfad ist. Hierbei ist der hochwertigste Teilstrom 1/2 des Abgleichbereichs. Der hochwertigste Teilstrom wird mit dem Datenbit dₙ₋₁ gesteuert. Das Datenbit dₙ₋₁ ist das signifikanteste Bit (MSB = Most Significant Bit). Rechts daneben in Fig. 3 ist der zweithochwertigste Teilstrom mit 1/4 des Abgleichbereichs. Dieser Teilstrom wird mit dem Datenbit dₙ₋₂ gesteuert. Ganz rechts befindet sich der niederwertigste Teilstrom mit dem Wert (1/2ⁿ) (eins durch 2 hoch n). Der niederwertigste Teilstrom wird durch das Datenbit d₀ gesteuert. Das Datenbit 0 ist das am wenigsten signifikanteste Bit (LSB = Least Significant Bit). Ganz rechts bei der Strombank 130 in Fig. 3 ist ein Transistor 131Z vorgesehen, von welchem der Strom I_{N} für die N-Seite in den Stromspiegel 133 eingespeist wird.

Der Ausgangsstromspiegel CAN_H 140 ist ein PMOS-Stromspiegel für Niederspannung (low voltage) zur CAN_H Ausgangstromerzeugung. Der Ausgangsstromspiegel CAN_L 145 ist ein NMOS-Stromspiegel für Niederspannung (low voltage) zur CAN_L Ausgangstromerzeugung. Die Stromspiegel 140, 145 sind mit im Layout identisch aufgebauten MOS-Niederspannungs-Transistoren gebildet, um gleiche Signalverzögerungen sowie gleiches Sättigungsverhalten im CAN_H- und CAN_L-Zweig der in Fig. 3 gezeigten Schaltung zu erhalten.

In Fig. 3 ist an den Ausgangsstromspiegel CAN_H 140 eine PMOS-Hochspannungs-Kaskode 141, die nachfolgend auch PMOS-HV-Kaskode 141 genannt ist, angeschlossen. Die PMOS-HV-Kaskode 141 wird für einen Fehlerfall "Kurzschluss von CAN_H gegen -27 V" benötigt. Darüber hinaus ist an den Ausgangsstromspiegel CAN_H 140 eine Verpolschutzdiode 142 zum Schutz der Schaltung gegen positive Überspannung von CAN_H angeschlossen.

Zudem ist in Fig. 3 an den Ausgangsstromspiegel CAN_L 145 eine NMOS-Hochspannungs-Kaskode 146, die nachfolgend auch NMOS-HV-Kaskode 146 genannt ist, angeschlossen. Die NMOS-HV-Kaskode 146 wird für einen Fehlerfall "Kurzschluss CAN_L gegen -27 V benötigt. Darüber hinaus ist an den Ausgangsstromspiegel CAN_L 145 eine Verpolschutzdiode 147 angeschlossen. Die Verpolschutzdiode 147 wird im Fehlerfall "Kurzschluss CAN_L gegen 40 V" benötigt. Zwischen der PMOS-HV_Kaskode 141 und der Verpolschutzdiode 147 ist der Bus 40 mit den Busadern 41, 42 geschaltet, welche mit dem Widerstand 143 abgeschlossen sind. Somit hat der Widerstand 143 den gleichen Widerstand wie der Wellenwiderstand des Busses 40, weshalb es zu keinen Reflexionen auf dem Bus 40 kommt. Hierbei steht die Busader 41 für die Übertragung des Signals CAN_H und die Busader 42 für die Übertragung des Signals CAN_L. Das Bezugszeichen 148 bezeichnet einen Kurzschlusspfad. Die NMOS-HV-Kaskode 146 ist mit einem Analog-/Digital-Wandler 149 verbunden. Der Analog-/Digital-Wandler 149 kann ein Komparator sein, welcher ein 1-Bit-Wandler ist. Der Analog-/Digital-Wandler 149 liegt an einem Transistor 1451 am Ausgang des Stromspiegels 145 und einem Schaltransistor 150 an, welcher als MOSFET ausgebildet ist und den Kurzschlusspfad 148 formt. Durch das Kurzschließen von zwei Stromquellen, den Transistoren 1401 und 1451, erhält man eine Konfiguration mit hoher Empfindlichkeit. Bereits geringste Stromunterschiede lassen das Potential am Eingang vom Analog-/Digital-Wandler 149 nach 0V oder zur Spannung / zum Potential VCC5 schalten. Ein einfacher Komparator als Analog-/Digital-Wandler 149 reicht in den meisten Fällen, um die Funktionalität zu erfüllen Das Bezugszeichen 151 bezeichnet einen flüchtigen Speicher.

Die zuvor beschriebene Schaltung ist in Bezug auf den Widerstand 143 stark vereinfacht. In der Realität sind an jedem Leitungsende der Busadern 41, 42 je zwei in Serie geschaltete 60 Ω Widerstände zum Abschluss vorhanden. Der jeweilige Mittelpunkt wird auf 2,5 V festgelegt.

In Fig. 3 ist ein Inverter 161 zur Ansteuerung des Gates der NMOS-HV-Kaskode 146 vorgesehen. Somit werden entweder die Kaskoden 146/141 oder der Schaltransistor 150 niederohmig geschaltet, um den Kurzschlusspfad 148 zu schalten. Der Inverter 161 ist zudem zur Ansteuerung des Gates einer NMOS-HV-Kaskode 162 vorgesehen, der an eine Stromquelle 163 angeschlossen ist. Die Stromquelle 163 gibt ihren Strom an die PMOS-Seite. Dieser Strom fließt in eine Zenerdiode 165 und einen Widerstand 164. Die Zenerdiode 165 bestimmt das negative Gatepotential für die HV-PMOS-Kaskode 141. Der Widerstand 164 sorgt dafür, dass beim Abschalten der Stromquelle 163 die Kaskode 141 ausgeschaltet wird. Zudem ist ein Inverter 160 zur Ansteuerung des Schaltransistors 150 vorgesehen. Der Inverter 160 kann jedoch auch ein Buffer sein.

Bei der Sendeeinrichtung 12 von Fig. 3 kann bei einem Verfahren zur Reduzierung von leitungsgebundenen Emissionen in dem Bussystem 1 ein Symmetrieabgleich folgendermaßen durchgeführt werden. Für den Symmetrieabgleich ist ein Schalter, umfassend die Transistoren PMOS-HV-Kaskode 141, NMOS-HV-Kaskode 146 und den Schalttransistor 150, vorgesehen, welcher die Strompfade von den Anschlüssen CAN_L oder CAN_H abtrennt und einen Kurzschluss zwischen den beiden strombestimmenden Elementen, herstellt. Bei dem vorliegenden Ausführungsbeispiel sind die beiden strombestimmenden Elemente Stromquellen, nämlich die Transistoren 1401 und 1451. Somit werden für den Symmetrieabgleich die Transistoren PMOS-HV-Kaskode 141 und NMOS-HV-Kaskode 146 hochohmig geschaltet und der Kurzschlusspfad 148 von dem Niederspannungs-PMOS-Transistor 1401 des Stromspiegels 140, welcher Transistor 1401 nachfolgend NV-PMOS-Transistor genannt ist, zu dem Niederspannungs-NMOS-Transistor 1451 des Stromspiegels 145, welcher Transistor 1451 nachfolgend NV-NMOS-Transistor genannt ist, eingeschaltet. Nun startet eine digitale Regelschleife, welche beispielsweise den Nennstrom des NV-PMOS-Transistors1401 von klein nach groß ändert. Am Anfang wird der Strom des NV-NMOS-Transistors 1451, welcher Strom auch NMOS-Strom genannt werden kann, dominieren, da der Strom des NV-PMOS-Transistors 1401, welcher Strom auch PMOS-Strom genannt werden kann, klein ist. Dadurch wird der Eingang des Analog-/Digital-Wandlers 149 nach Masse GND gezogen. Mit Vergrößern des PMOS-Stroms wird der Eingang des Analog-/Digital-Wandlers 149 plötzlich zu einem höheren Spannungswert gezogen. An diesem Punkt ist der PMOS-Strom größer als der NMOS-Strom. Mit hinreichend kleinen Stromschritten des Digital-Analog-Wandlers 130 kann erreicht werden, dass der P- und NMOS-Strom annähernd gleich sind. Das Steuerwort des Digital-Analog-Wandlers 130, das auch DAC-Steuerwort genannt werden kann, wird in dem flüchtigen Speicher 151, insbesondere Register, abgelegt und bei jedem normalen Sendevorgang der Sendeeinrichtung 12 verwendet. Der Abgleich wird vom Digitalteil bzw. dem Digital-Analog-Wandler 130 zyklisch ausgeführt, z. B. nach jeden Aufwachen der Sendeeinrichtung 12 aus dem Niedrigleistungszustand (power-down Zustand).

Mit der Sendeeinrichtung 12 von Fig. 3 wird also ein Verfahren zur Reduzierung von leitungsgebundenen Emissionen in dem Bussystem 1 ausgeführt. Hierbei führt die Sendeeinrichtung 12 zur Symmetrierung des Dominant-Buszustands einen Abgleich durch, wie zuvor beschrieben.

Die benötigte Spannungsfestigkeit wird mittels Kaskodestufen und einem Schalttransistor 150 erreicht. Die Kaskodestufen sind aus MOS-Hochspannungs-Transistoren gebildet, nämlich den Kaskoden 141, 146, 132.

Wie aus Fig. 3 ersichtlich, ist bei der Sendeeinrichtung 12 die zuvor beschriebene Schaltung zur Symmetrierung des Dominant-Buszustands weitgehend vom Bus 40 getrennt, der durch die Busadern 41, 42 und den Widerstand 143 repräsentiert wird. Dieser Vorteil wird durch die kaskoden Transistoren erzielt, nämlich die Kaskoden 141, 146. Damit werden eingestrahlte Störungen, wie durch DPI, BCI, etc., von empfindlichen Blöcken, wie dem Digital-Analog-Wandler 130 ferngehalten.

Somit verwendet die Erfindung die Aufteilung der CAN-Treibertransistoren in Niedrigspannung-Signaltransistor und Hochspannung-Kaskodentransistor. Wenn die CAN-Sendeeinrichtung 12 im Rezessivbetrieb ist, bei welchem die Treibertransistoren ausgeschaltet sind, dann ist es möglich einen On-Chip-Abgleich der Symmetrie des Dominant-Buszustands durchzuführen. Alternativ ist es jedoch auch möglich, das zuvor beschriebene Verfahren als eingebauten Selbsttest während eines Endtests der CAN-Sendeeinrichtung 12, insbesondere als einmaligen Abgleich beim Endtest, zu verwenden und die ermittelten Trimmwerte für eine spätere Verwendung fest in ein OTP-Register zu speichern, insbesondere zu brennen.

Alle zuvor beschriebenen Ausgestaltungen des Bussystems 1, der Teilnehmerstationen 10, 30, der Sendeeinrichtung 12 und des Verfahrens können einzeln oder in allen möglichen Kombinationen Verwendung finden. Insbesondere ist eine beliebige Kombination der Merkmale des Ausführungsbeispiels möglich. Zusätzlich sind insbesondere folgende Modifikationen denkbar.

Das Bussystem 1 gemäß dem Ausführungsbeispiel ist insbesondere ein CAN-Netzwerk oder ein CAN FD-Netzwerk oder ein FlexRay-Netzwerk.

Die Anzahl und Anordnung der Teilnehmerstationen 10, 20, 30 in dem Bussystem 1 ist beliebig. Insbesondere können auch nur Teilnehmerstationen 10 oder nur Teilnehmerstationen 30 oder nur Teilnehmerstationen 10, 30 in dem Bussystem 1 der Ausführungsbeispiele vorhanden sein.

Die zuvor beschriebenen Teilnehmerstationen 10, 30 und das von ihnen ausgeführte Verfahren kann besonders vorteilhaft bei einem modifizierten Datenprotokoll angewendet werden, welches am 02.05.2011 auf der Internet-Seite http://www.semiconductors.bosch.de/veröffentlichte Dokument "CAN with Flexible Data-Rate, White Paper, Version 1.0" veröffentlicht wurde und welches unter anderem eine Vergrößerung des Datenfeldes sowie für einen Teil der CAN-Nachricht nach erfolgter Arbitrierung eine Verkürzung der Bitlänge ermöglicht.

Der zuvor beschriebene Schalter, welcher die Strompfade von den Anschlüssen CAN_L oder CAN_H abtrennt und einen Kurzschluss zwischen den beiden strombestimmenden Elementen herstellt, kann auch durch einen oder mehr zusätzliche Schaltelemente gebildet sein, welche die genannte Funktion anstelle der PMOS-HV-Kaskode 141 und NMOS-HV-Kaskode 146 realisieren. Der Schalter kann eine beliebige für diesen Zweck geeignete Ausgestaltung aufweisen.

Die Teilnehmerstationen 10, 30 stellen besonders für CAN-FD eine Möglichkeit dar, die Sendegüte von CAN-FD in den Bereich von üblichen CAN Übertragungen bei Nutzung einer deutlich höheren Datenrate anzuheben.

Die Funktionalität des zuvor beschriebenen Ausführungsbeispiels lässt sich auch in einem Transceiver bzw. einer Sende-/Empfangseinrichtung 13 oder in einer Kommunikationssteuereinrichtung 11 usw. umsetzen. Zusätzlich oder alternativ kann die Sendeeinrichtung 12 in existierende Produkte integriert werden.

## Patentansprüche

1. Teilnehmerstation (10; 30) für ein Bussystem (1), mit einem Digital-Analog-Wandler (131C bis 131J) zum Wandeln eines digitalen Signals in ein analoges Signal, und einem Analog-/Digital-Wandler (149),
wobei der Digital-Analog-Wandler (131C bis 131J) und der Analog-/DigitalWandler (149) für einen Symmetrieabgleich des Dominant-Buszustands des Bussystems (1) verschaltet sind, **gekennzeichnet durch**:
einen NMOS-Hochspannungs-Kaskodentransistor (132), der an den Ausgang des Digital-Analog-Wandlers (131C bis 131J) angeschlossen ist,
einen PMOS-Ausgangsstromspiegel (140), der an den Ausgang des Hochspannungs-Kaskodentransistors (132) angeschlossen ist und welcher den Strom zu einer ersten Busader (41) leitet und ein Stromspiegel für Niederspannung zur Ausgangsstromerzeugung für die erste Busader (41) ist,
einen PMOS-Hochspannungs-Kaskodentransistor (141), der an einen Niederspannungs-PMOS- Transistor (1401) am Ausgang des Ausgangsstromspiegels (140) und einen Anschluss für die erste Busader (41) angeschlossen ist,
einen PMOS-Stromspiegel für Niederspannung (133) welcher dem Digital-Analog-Wandler (131C bis 131J) nachgeschaltet ist,
einen NMOS-Ausgangsstromspiegel (145), der an den Ausgang des Stromspiegels (133) angeschlossen ist und welcher den Strom zu einer zweiten Busader (42) leitet und ein Stromspiegel für Niederspannung zur Ausgangsstromerzeugung für die zweite Busader (42) ist,
einen NMOS-Hochspannungs-Kaskodentransistor (146), der an einen Niederspannungs-NMOS-Transistor (1451) am Ausgang des NMOS-Ausgangsstromspiegels (145) und einen Anschluss für die zweite Busader (42) angeschlossen ist.

2. Teilnehmerstation (10; 30) nach Anspruch 1, wobei der Digital-Analog-Wandler (130) zum zyklischen Ausführen und/oder zum On-Chip-Ausführen des Symmetrieabgleichs ausgestaltet ist.

3. Teilnehmerstation (10; 30) nach Anspruch 1 oder 2, zudem mit einem flüchtigen Speicher (151), in welchem ein Steuerwort des Digital-Analog-Wandlers (130) zum Durchführen des Symmetrieabgleichs abgelegt ist.

4. Teilnehmerstation (10; 30) nach Anspruch 3,
wobei der Digital-Analog-Wandler (131C bis 131J) als Stromquellen-Ausgang mit binärer Gewichtung erste Transistoren (131C bis 131F) in einer Anzahl aufweist, die einer Wortbreite des Steuerworts entspricht, wobei in Reihe zu jedem der ersten Transistoren (131C bis 131F) ein zweiter Transistor (131G bis 131J) als Schalter geschaltet ist,
wobei die ersten Transistoren (131C bis 131F) mit dem Strompfad zu dem Anschluss für die zweite Busader (42) verbunden sind, und
wobei die zweiten Transistoren (131G bis 131J) mit dem Strompfad zu dem Anschluss für die erste Busader (41) verbunden sind.

5. Teilnehmerstation (10; 30) nach einem der vorangehenden Ansprüche, wobei über den NMOS-Hochspannungs-Kaskodentransistor (132) der Digital-Analog-Wandler (131C bis 131J) mit dem Strompfad zu dem Anschluss für die erste Busader (41) verbunden ist.

6. Teilnehmerstation (10; 30) nach einem der vorangehenden Ansprüche, wobei der Digital-Analog-Wandler (131C bis 131J) mit einem Strompfad zu einem Anschluss für die erste Busader (41) verbunden ist und mit einem Strompfad zu einem Anschluss für die zweite Busader (42) verbunden ist.

7. Teilnehmerstation (10; 30) nach Anspruch 6, wobei über den PMOS-Stromspiegel (133) der Digital-Analog-Wandler (131C bis 131J) mit dem Strompfad zu dem Anschluss für die zweite Busader (42) verbunden ist.

8. Teilnehmerstation (10; 30) nach einem der vorangehenden Ansprüche, zudem mit einem Schalter (141, 146) zum Trennen des Digital-Analog-Wandlers (130) und des Analog-/Digital-Wandlers (149) von einem Bus (40) des Bussystems (1), um den Symmetrieabgleich durchzuführen.

9. Teilnehmerstation (10; 30) nach Anspruch 8, wobei der Schalter eine PMOS-HV-Kaskode (141) und eine NMOS-HV-Kaskode (146) umfasst, welche zum Durchführen des Symmetrieabgleichs hochohmig schaltbar sind, um den Digital-Analog-Wandler (130) und den Analog-/DigitalWandler (149) von dem Bus (40) des Bussystems (1) zu trennen.

10. Teilnehmerstation (10; 30) nach Anspruch 9, zudem mit einem Kurzschlusspfad (148) vom Niederspannungs-NMOS-Transistor (1451) zum Niederspannungs-PMOS-Transistor (1401) zum Starten einer digitalen Regelschleife für den Symmetrieabgleich.

11. Bussystem (1), mit
einem Bus (40), und
mindestens zwei Teilnehmerstationen (10, 20, 30), welche über den Bus (40) derart miteinander verbunden sind, dass sie miteinander kommunizieren können,
wobei mindestens eine der mindestens zwei Teilnehmerstationen (10, 20, 30) eine Teilnehmerstation (10; 30) nach einem der vorangehenden Ansprüche ist.

12. Verfahren zur Reduzierung von leitungsgebundenen Emissionen in einem Bussystem (1), wobei eine Teilnehmerstation (10; 30) des Bussystems gemäß einem der Ansprüche 1-10 ausgestaltet ist und der Digital-Analog-Wandler (131C bis 131J) und der Analog-/Digital-Wandler (149) derart miteinander verschaltet werden, dass der Digital-Analog-Wandler (131C bis 131J) und der Analog-/Digital-Wandler (149) einen Symmetrieabgleich des Dominant-Buszustands des Bussystems (1) durchführen.

13. Verfahren nach Anspruch 12,
wobei das Ausführen des Symmetrieabgleichs zyklisch und/oder als On-Chip-Symmetrieabgleich ausgeführt wird, und/oder wobei zum Durchführen des Symmetrieabgleichs ein Steuerwort des Digital-Analog-Wandlers (130) verwendet wird, das in einem flüchtigen Speicher (151) abgelegt ist.

14. Verfahren nach einem der Ansprüche 12 oder 13, wobei zum Durchführen des Symmetrieabgleichs der PMOS-Hochspannungs-Kaskodentransistor (141) und der NMOS-Hochspannungs-Kaskodentransistor (146) hochohmig geschaltet werden, um den Digital-Analog-Wandler (130) und den Analog-/Digital-Wandler (149) von einem Bus (40) des Bussystems (1) zu trennen, um mit einem Kurzschlusspfad (148) vom Niederspannungs-PMOS-Transistor (1401) zum Nlederspannungs-NMOS-Transistor (1451) eine digitale Regelschleife, bei welcher der Strom des Niederspannungs-NMOS-Transistors (1451) und der Strom des Niederspannungs-PMOS-Transistors (1401) auf einen annähernd gleichen Wert geregelt wird, für den Symmetrieabgleich zu starten.

## Claims

1. Subscriber station (10; 30) for a bus system (1), having
a digital-to-analogue converter (131C to 131J) for converting a digital signal into an analogue signal, and an analogue-to-digital converter (149),
wherein the digital-to-analogue converter (131C to 131J) and the analogue-to-digital converter (149) are interconnected for a balance adjustment of the dominant bus state of the bus system (1), **characterized by**:
an NMOS high-voltage cascode transistor (132), which is connected to the output of the digital-to-analogue converter (131C to 131J),
a PMOS output current mirror (140), which is connected to the output of the high-voltage cascode transistor (132) and which conducts the current to a first bus wire (41) and is a current mirror for low voltage for producing output current for the first bus wire (41),
a PMOS high-voltage cascode transistor (141), which is connected to a low-voltage PMOS transistor (1401) at the output of the output current mirror (140) and to a connection for the first bus wire (41),
a PMOS current mirror for low voltage (133), which is connected downstream of the digital-to-analogue converter (131C to 131J),
an NMOS output current mirror (145), which is connected to the output of the current mirror (133) and which conducts the current to a second bus wire (42) and is a current mirror for low voltage for producing output current for the second bus wire (42),
an NMOS high-voltage cascode transistor (146), which is connected to a low-voltage NMOS transistor (1451) at the output of the NMOS output current mirror (145) and a connection for the second bus wire (42).

2. Subscriber station (10; 30) according to Claim 1, wherein the digital-to-analogue converter (130) is configured for cyclic performance and/or for on-chip performance of the balance adjustment.

3. Subscriber station (10; 30) according to Claim 1 or 2, also having a volatile memory (151) that stores a control word of the digital-to-analogue converter (130) for performance of the balance adjustment.

4. Subscriber station (10; 30) according to Claim 3, wherein the digital-to-analogue converter (131C to 131J) has, as a current source output with binary weighting, first transistors (131C to 131F) in a number that corresponds to a word length of the control word, wherein each of the first transistors (131C to 131F) has a second transistor (131G to 131J) connected in series with it as a switch,
wherein the first transistors (131C to 131F) are connected to the current path to the connection for the second bus wire (42), and
wherein the second transistors (131G to 131J) are connected to the current path to the connection for the first bus wire (41).

5. Subscriber station (10; 30) according to one of the preceding claims, wherein the NMOS high-voltage cascode transistor (132) connects the digital-to-analogue converter (131C to 131J) to the current path to the connection for the first bus wire (41).

6. Subscriber station (10; 30) according to one of the preceding claims, wherein the digital-to-analogue converter (131C to 131J) is connected to a current path to a connection for the first bus wire (41) and to a current path to a connection for the second bus wire (42) .

7. Subscriber station (10; 30) according to Claim 6, wherein the PMOS current mirror (133) connects the digital-to-analogue converter (131C to 131J) to the current path to the connection for the second bus wire (42) .

8. Subscriber station (10; 30) according to one of the preceding claims, also having a switch (141, 146) for isolating the digital-to-analogue converter (130) and the analogue-to-digital converter (149) from a bus (40) of the bus system (1) in order to perform the balance adjustment.

9. Subscriber station (10; 30) according to Claim 8, wherein the switch comprises a PMOS HV cascode (141) and an NMOS HV cascode (146), which are switchable to high impedance for performing the balance adjustment in order to isolate the digital-to-analogue converter (130) and the analogue-to-digital converter (149) from the bus (140) of the bus system (1).

10. Subscriber station (10; 30) according to Claim 9, also having a short-circuit path (148) from the low-voltage NMOS transistor (1451) to the low-voltage PMOS transistor (1401) to start a digital control loop for the balance adjustment.

11. Bus system (1), having
a bus (40), and
at least two subscriber stations (10, 20, 30), which are connected to one another via the bus (40) such that they can communicate with one another,
wherein at least one of the at least two subscriber stations (10, 20, 30) is a subscriber station (10; 30) according to one of the preceding claims.

12. Method for reducing line-conducted emissions in a bus system (1), wherein a subscriber station (10; 30) of the bus system is configured according to one of Claims 1-10 and the digital-to-analogue converter (131C to 131J) and the analogue-to-digital converter (149) are interconnected such that the digital-to-analogue converter (131C to 131J) and the analogue-to-digital converter (149) perform a balance adjustment of the dominant bus state of the bus system (1).

13. Method according to Claim 12,
Wherein the performance of the balance adjustment is carried out cyclically and/or as on-chip balance adjustment and/or
wherein the balance adjustment is performed by using a control word of the digital-to-analogue converter (130) that is stored in a volatile memory (151).

14. Method according to either of Claims 12 or 13, wherein the balance adjustment is performed by virtue of the PMOS high-voltage cascode transistor (141) and the NMOS high-voltage cascode transistor (146) being switched to high impedance in order to isolate the digital-to-analogue converter (130) and the analogue-to-digital converter (149) from a bus (40) of the bus system (1) in order to use a short-circuit path (148) from the low-voltage PMOS transistor (1401) to the low-voltage NMOS transistor (1451) to start a digital control loop, in the case of which the current of the low-voltage NMOS transistor (1451) and the current of the low-voltage PMOS transistor (1401) are regulated to an approximately identical value, for the balance adjustment.

## Revendications

1. Station d'utilisateur (10 ; 30) pour un système de bus (1), comprenant un convertisseur numérique/analogique (131C à 131J) destiné à convertir un signal numérique en un signal analogique, et un convertisseur analogique/numérique (149),
le convertisseur numérique/analogique (131C à 131J) et le convertisseur analogique/numérique (149) étant connectés pour un alignement symétrique de l'état de bus dominant du système de bus (1), **caractérisée par** :
un transistor cascode à haute tension NMOS (132) qui est raccordé à la sortie du convertisseur numérique/analogique (131C à 131J),
un miroir de courant de sortie PMOS (140) qui est raccordé à la sortie du transistor cascode à haute tension (132) et qui conduit le courant vers un premier fil de bus (41) et qui est un miroir de courant pour la basse tension destinée à générer un courant de sortie pour le premier fil de bus (41),
un transistor cascode à haute tension PMOS (141) qui est raccordé à un transistor PMOS à basse tension (1401) à la sortie du miroir de courant de sortie (140) et à une borne pour le premier fil de bus (41),
un miroir de courant PMOS pour la basse tension (133) qui est branché en aval du convertisseur numérique/analogique (131C à 131J),
un miroir de courant de sortie NMOS (145) qui est raccordé à la sortie du miroir de courant (133) et qui conduit le courant vers un deuxième fil de bus (42) et qui est un miroir de courant pour la basse tension destinée à générer un courant de sortie pour le deuxième fil de bus (42),
un transistor cascode à haute tension NMOS (146) qui est raccordé à un transistor NMOS à basse tension (1451) à la sortie du miroir de courant de sortie NMOS (145) et à une borne pour le deuxième fil de bus (42).

2. Station d'utilisateur (10 ; 30) selon la revendication 1, le convertisseur numérique/analogique (130) étant configuré pour l'exécution cyclique et/ou pour l'exécution sur puce de l'alignement symétrique.

3. Station d'utilisateur (10 ; 30) selon la revendication 1 ou 2, comprenant en outre une mémoire volatile (151) dans laquelle est stocké un mot de commande du convertisseur numérique/analogique (130) pour l'exécution de l'alignement symétrique.

4. Station d'utilisateur (10 ; 30) selon la revendication 3, le convertisseur numérique/analogique (131C à 131J) possédant, en tant que sortie de sources de courant avec pondération binaire, des premiers transistors (131C à 131F) dans un nombre qui correspond à une largeur de mot du mot de commande, un deuxième transistor (131G à 131J) faisant office de commutateur étant branché en série avec chaque premier transistor (131C à 131F), les premiers transistors (131C à 131F) étant reliés au trajet de courant vers la borne pour le deuxième fil de bus (42) et les deuxièmes transistors (131G à 131J) étant reliés au trajet de courant vers la borne pour le premier fil de bus (41).

5. Station d'utilisateur (10 ; 30) selon l'une des revendications précédentes, le convertisseur numérique/analogique (131C à 131J) étant relié au trajet de courant vers la borne pour le premier fil de bus (41) par le biais du transistor cascode à haute tension NMOS (132) .

6. Station d'utilisateur (10 ; 30) selon l'une des revendications précédentes, le convertisseur numérique/analogique (131C à 131J) étant relié à un trajet de courant vers une borne pour le premier fil de bus (41) et à un trajet de courant vers une borne pour le deuxième fil de bus (42).

7. Station d'utilisateur (10 ; 30) selon la revendication 6, le convertisseur numérique/analogique (131C à 131J) étant relié au trajet de courant vers la borne pour le deuxième fil de bus (42) par le biais du miroir de courant PMOS (133).

8. Station d'utilisateur (10 ; 30) selon l'une des revendications précédentes, comprenant en outre un commutateur (141, 146) destiné à déconnecter le convertisseur numérique/analogique (130) et le convertisseur analogique/numérique (149) d'un bus (40) du système de bus (1) afin de réaliser l'alignement symétrique.

9. Station d'utilisateur (10 ; 30) selon la revendication 8, le commutateur comportant un montage cascode HV PMOS (141) et un montage cascode HV NMOS (146), lesquels peuvent être connectés à haute impédance pour réaliser l'alignement symétrique afin de déconnecter le convertisseur numérique/analogique (130) et le convertisseur analogique/numérique (149) du bus (40) du système de bus (1).

10. Station d'utilisateur (10 ; 30) selon la revendication 9, comprenant en outre un trajet de court-circuit (148) du transistor NMOS à basse tension (1451) au transistor PMOS à basse tension (1401) pour démarrer une boucle de régulation numérique pour l'alignement symétrique.

11. Système de bus (1), comprenant un bus (40), et
au moins deux stations d'utilisateur (10, 20, 30) qui sont reliées les unes aux autres par le biais du bus (40) de telle sorte qu'elles peuvent communiquer ensemble, au moins l'une des au moins deux stations d'utilisateur (10, 20, 30) étant une station d'utilisateur (10 ; 30) selon l'une des revendications précédentes.

12. Procédé de réduction des émissions liées à la ligne dans un système de bus (1), une station d'utilisateur (10 ; 30) du système de bus étant configurée selon l'une des revendications 1 à 10 et le convertisseur numérique/analogique (131C à 131J) et le convertisseur analogique/numérique (149) étant connectés l'un à l'autre de telle sorte que le convertisseur numérique/analogique (131C à 131J) et le convertisseur analogique/numérique (149) réalisant un alignement symétrique de l'état de bus dominant du système de bus (1) .

13. Procédé selon la revendication 12, l'exécution de l'alignement symétrique étant exécutée de manière cyclique et/ou en tant qu'alignement symétrique sur puce et/ou un mot de commande du convertisseur numérique/analogique (130) étant utilisé pour réaliser l'alignement symétrique, lequel est stocké dans une mémoire volatile (151).

14. Procédé selon l'une des revendications 12 et 13, le transistor cascode à haute tension PMOS (141) et le transistor cascode à haute tension NMOS (146) étant connectés à haute impédance pour réaliser l'alignement symétrique afin de déconnecter le convertisseur numérique/analogique (130) et le convertisseur analogique/numérique (149) d'un bus (40) du système de bus (1), afin de démarrer pour l'alignement symétrique, avec un trajet de court-circuit (148) du transistor PMOS à basse tension (1401) au transistor NMOS à basse tension (1451), une boucle de régulation numérique par laquelle le courant du transistor NMOS à basse tension (1451) et le courant du transistor PMOS à basse tension (1401) sont régulés à une valeur approximativement identique.
